# EUROPÄISCHE PATENTSCHRIFT

(11) **EP 0 931 439 B1**
(45) Veröffentlichungstag und Bekanntmachung des Hinweises auf die Patenterteilung: **14.06.2000**
(21) Anmeldenummer: 97909337.4
(22) Anmeldetag: 30.09.1997
(51) Int. Cl.: H05K 3/46, H05K 3/02

(54) **VERFAHREN ZUR BILDUNG VON MINDESTENS ZWEI VERDRAHTUNGSEBENEN AUF ELEKTRISCH ISOLIERENDEN UNTERLAGEN**
METHOD FOR BUILDING AT LEAST TWO WIRING LEVELS ON ELECTRICALLY INSULATED SUPPORTS
TECHNIQUE POUR CONSTITUER AU MOINS DEUX NIVEAUX DE CABLAGE SUR DES SUPPORTS ISOLES ELECTRIQUEMENT

(30) Priorität: 30.09.1996 DE 19640430
(43) Veröffentlichungstag der Anmeldung: 28.07.1999
(73) Patentinhaber: Siemens S.A., 1060 Bruxelles (BE)
(72) Erfinder: HEERMAN, Marcel, B-9200 Merelbeke (BE); VAN PUYMBROECK, Jozef, B-8020 Oostkamp (BE); MATTELIN, Antoon, B-8020 Oostkamp (BE)
(74) Vertreter: Zedlitz, Peter, Dipl.-Inf.
(86) Internationale Anmeldenummer: EP9705366
(87) Internationale Veröffentlichungsnummer: WO9815159

(56) Entgegenhaltungen:
- EP-A- 0 361 192
- EP-A- 0 415 336
- EP-A- 0 602 258
- DE-A- 3 732 249
- DE-A- 4 103 834
- US-A- 4 894 115
- US-A- 5 364 493
- US-A- 5 509 553
- J. KICKELHAIN: "Mikrostrukturierung mittels Lasertechnik" SMD-MAGAZIN, Nr. 3/4, 1990, Seiten 38-40, XP000351835

## Beschreibung

Aus der EP-A-0 062 300 ist ein Verfahren zur Herstellung von Leiterplatten bekannt, bei welchem eine ganzflächig auf eine Metallschicht aufgebrachte metallische Ätzresistschicht mittels eines Laserstrahls selektiv wieder entfernt wird und das Leiterbild durch Abätzen der derart freigelegten Metallschicht strukturiert werden kann. Um bei diesem bekannten Verfahren die Metallschicht zwischen den Leiterbahnen durch Ätzen vollständig entfernen zu können, muß zuvor die darüberliegende Ätzresistschicht ebenfalls vollständig entfernt werden. Diese Entfernung der Ätzresistschicht, die mit einem Laserstrahl vorgenommen wird, ist jedoch aufwendig und zeitraubend. Dies trifft insbesondere dann zu, wenn die Leiterbahnen relativ weit auseinander liegen und die Flächen der mit dem Laser abzutragenden Ätzresistschicht somit relativ groß sind.

Bei einem aus der EP-A- 0 361 192 bekannten Verfahren zur Herstellung von Leiterplatten werden im Unterschied zu dem vorstehend beschriebenen Verfahren nur die unmittelbar an das spätere Leiterbild angrenzenden Bereiche der Ätzresistschicht mittels elektromagnetischer Strahlung, vorzugsweise Laserstrahlung, entfernt. Die Konturbeschreibung mittels der elektromagnetischen Strahlung ist also als eine enge Umfahrung oder Umschreibung des Leiterbildes anzusehen, die im Hinblick auf die geringe Flächenausdehnung der abzutragenden Ätzresistschicht rasch vorgenommen werden kann. Die nicht dem Leiterbild entsprechenden Bereiche werden anodisch kontaktiert, worauf hier die Ätzresistschicht elektrolytisch abgetragen und die dadurch freigelegte Metallschicht weggeätzt werden kann. Die nicht dem Leiterbild entsprechenden Inselbereiche können aber auch stehen bleiben, ohne die Funktion der Leiterplatte zu beeinträchtigen. Gegebenenfalls können die Inselbereiche auch an Masse oder ein einheitliches Potential gelegt werden und die Funktion von Abschirmungen übernehmen.

Bei mehrlagigen Leiterplatten werden die einzelnen Verdrahtungsebenen mittels sog. Durchkontaktierungen direkt leitend miteinander verbunden. Die Miniaturisierung der Leiterplatten wird unter anderem durch den Platzbedarf dieser Durchkontaktierungen begrenzt. Der Platzbedarf ist durch die Fläche, die für die Durchkontaktierung in der Verdrahtungsebene freigehalten werden muß, sowie durch die Länge der Durchkontaktierung festgelegt. In ihrer Länge erstreckt sich die Durchkontaktierung zwischen den zu verbindenden Verdrahtungsebenenen, ggf. durch die gesamte Dicke der Leiterplatte. Die Durchkontaktierungen können sich auch durch die gesamte Dicke vorgefertigter Zwischenlaminate innerhalb der mehrlagigen Leiterplatte erstrecken.

Aus der EP-A- 0 164 564 ist es bekannt, in einem Laminat mit der Schichtenfolge Metall-Dielektrikum-Metall mit Hilfe eines Excimer-Lasers Sacklöcher zu erzeugen. Die oberste Metallschicht des Laminats wird hierbei als Lochmaske verwendet, deren Lochbild mittels Fototechnik übertragen und durch nachfolgendes Ätzen hergestellt wird. Das im Lochbereich dieser Maske freiliegende Dielektrikum wird dann durch die Einwirkung des Excimer-Lasers abgetragen, bis die unterste Metallschicht erreicht ist und den Abtragungsprozeß beendet. Mit dem bekannten Verfahren werden insbesondere bei der Herstellung mehrlagiger Leiterplatten die erforderlichen Durchkontaktierungslöcher in Form von Sacklöchern hergestellt.

Aus der EP-A- 0 478 313 ist das sog. SLC-Verfahren (Surface Laminar Circuit) bekannt, bei welchem zunächst auf einem Basissubstrat eine erste Verdrahtungsebene erzeugt wird. Auf diese erste Verdrahtungsebene wird dann durch Siebdruck oder durch Vorhanggießen eine dielektrische Schicht aus einem fotoempfindlichen Epoxidharz aufgebracht. Auf fotolithografischem Wege durch Belichten und Entwickeln werden dann in der dielektrischen Schicht Sacklöcher hergestellt. Nach dem chemischen und galvanischen Verkupfern der Lochwände und der Oberfläche der dielektrischen Schicht wird die zweite Verdrahtungsebene durch fotolithografische Strukturierung der abgeschiedenen Kupferschicht erzeugt. Durch alternierendes Aufbringen von fotoempfindlichen dielektrischen Schichten und Kupferschichten können dann in der geschilderten Weise weitere Verdrahtungsebenen hergestellt werden.

Aus der US-A-5 509 553 ist ein Verfahren zur Herstellung von Multichip Modulen bekannt, bei welchem auf einer elektrisch isolierenden Unterlage zwei oder gegebenenfalls auch drei Verdrahtungsebenen gebildet werden. Die Bildung der Verdrahtungsebenen umfaßt folgende Schritte:
a.) Aufbringen einer ersten Metallisierung auf die Unterlage, insbesondere durch Sputtern;
b.) Entfernen der ersten Metallisierung mittels Laserstrahlung in den nicht dem späteren Leitermuster der ersten Verdrahtungsebene entsprechenden Bereichen;
c.) Aufbringen einer Dielektrikumsschicht auf die im Schritt b.) gebildete erste Verdrahtungsebene;
d.) Einbringen von Sacklöchern in die Dielektrikumsschicht mittels Laserstrahlung, wobei das dielektrische Material bis zu im Leitermuster der ersten Verdrahtungsebene vorgesehenen Pads abgetragen wird;
e.) Aufbringen einer zweiten Metallisierung auf die Oberfläche der Dielektrikumsschicht, insbesondere durch Sputtern, wobei auch die Sacklöcher mit Metall gefüllt werden;
f.) Entfernen der zweiten Metallisierung mittels Laserstrahlung in den nicht dem späteren Leitermuster der zweiten Verdrahtungsebene entsprechenden Bereichen.

Zur Bildung einer dritten Verdrahtungsebene können die Schritte c.) bis f.) in entsprechend abgewandelter Form wiederholt werden. Die an den Stellen der Sacklöcher bzw. der Durchkontaktierungen vorgesehenen Pads der Leitermuster der Verdrahtungsebenen sind wesentlich breiter, als die von diesen Pads wegführenden Leiterbahnen.

Aus der DE-A-41 03 834 ist ein Verfahren zur Herstellung von Leiterplatten bekannt, bei welchem von einer elektrisch isolierenden Unterlage ausgegangen wird, die mit einer Metallisierung versehen wird. Um bei der Strukturierung der Metallisierung mittels Laserstrahlung eine Schädigung der Oberfläche der Unterlage zu vermeiden, wird auf die Metallisierung zunächst eine für Infrarotstrahlung durchlässige und gegen Ätzmittel resistente Schicht aufgebracht. Anschließend wird zur Herstellung des gewünschten Leitermusters die Metallisierung mittels des Laserstrahls unter Belassung einer Restmetallstärke strukturiert, worauf die Restmetallstärke bis zur Oberfläche der Unterlage abgeätzt und dananch der noch verbleibende Teil der resistenten Schicht entfernt wird.

Der Erfindung liegt das Problem zugrunde, ein einfaches und- wirtschaftliches Verfahren zur Bildung von mindestens zwei Verdrahtungsebenen auf elektrisch isolierenden Unterlagen zu schaffen, welches insbesondere auch zum Aufbau von Multi-Chip-Modulen geeignet ist und welches eine deutliche Reduzierung des für das gesamte Leitermuster einer Verdrahtungsebene erforderlichen Platzes ermöglicht.

Die erfindungsgemäße Lösung dieses Problems erfolgt durch die in den Patentansprüchen 1 und 6 angegebenen Verfahrensschritte.

Der Erfindung liegt die Erkenntnis zugrunde, daß durch den Einsatz der Lasertechnik sowohl zur Strukturierung der Leitermuster in den Verdrahtungsebenen als auch zum Einbringen von Sacklöchern in die Dielektrikumsschichten sich gegeüber den konventionellen Verfahren erhebliche Vorteile ergeben. So werden im Vergleich mit den üblichen Lithographieverfahren bei entsprechenden Strukturfeinheiten allenfalls geringe Reinraumansprüche gestellt. Auf einen Einsatz von Photomasken und entsprechender Klimatisierungseinrichtungen kann vollständig verzichtet werden. Außerdem erlaubt die Tiefenschärfe des Lasers die Bearbeitung unebener Flächen, d.h. die bei der normalen Lithographie geltenden Planarisierungsanforderungen sind bei dem erfindungsgemäßen Verfahren nicht anzuwenden. Insbesondere führen Unebenheiten in der Bauelementenanschlußlage, die durch darunterliegende Sacklöcher entstehen können, zu keinerlei Schwierigkeiten. Hervorzuheben ist schließlich auch noch, daß die angestrebte Struktur - und Bohrfeinheit durch den Einsatz moderner Lasersysteme und spezifischer Anlagen bei hohem Bearbeitungsgeschwindigkeiten unter wirtschaftlichen Bedingungen realisiert werden kann. Durch die gleichbleibenden Breiten der Leiterbahnen auch im Bereich der Durchkontaktierungen kann das gesamte Leitermuster einer Verdrahtungsebene auf einem Bruchteil des bisher erforderlichen Platzes untergebracht werden. Bei Leiterbahnbreiten von 50 µm kann der Raumbedarf gegenüber den bisher üblichen Leiterbahnbreiten von 100 um beispielsweise um 75 Prozent reduziert werden.

Die Laserstrukturierung der einzelnen Metallisierungen zur Bildung der Verdrahtungsebenen kann dabei gemäß Anspruch 1 durch direkte Strukturierung der Metallisierungen oder gemäß Anspruch 6 durch die Strukturierung von Ätzresistschichten und anschließendes Ätzen erfolgen. Im Falle der direkten Strukturierung kann die Metallisierung bis zur darunterliegenden Schicht vollständig abgetragen werden oder es kann eine dünne Restschicht verbleiben, die dann anschließend durch Differenzätzen entfernt wird.

Vorteilhafte Ausgestaltungen der Erfindung sind in den Unteransprüchen 2 bis 5 und 7 bis 23 angegeben.

Ausführungsbeispiele der Erfindung sind in der Zeichnung dargestellt und werden im folgenden näher beschrieben.

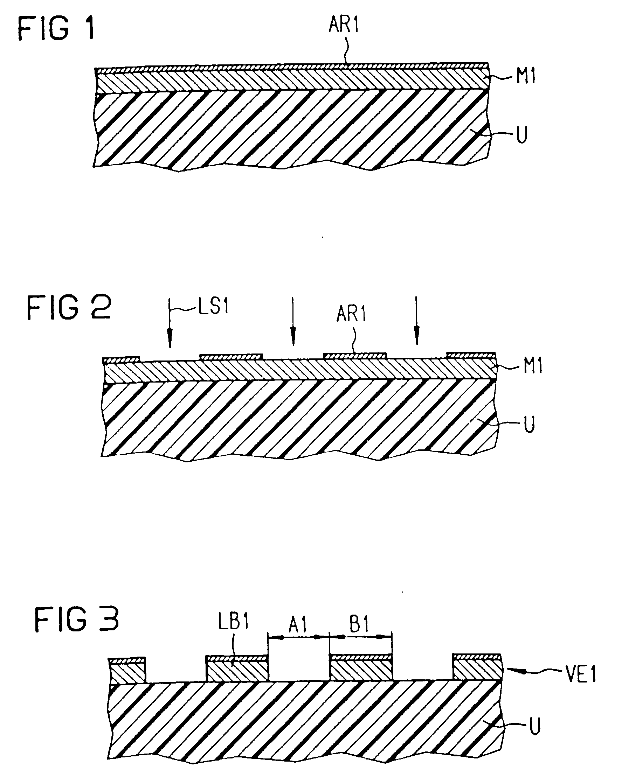

Die Figuren 1 bis 13 zeigen in stark vereinfachter schematischer Darstellung verschiedene Verfahrensstadien bei der Bildung von drei Verdrahtungsebenen auf einer elektrisch isolierenden Unterlage, wobei die einzelnen Verdrahtungsebenen jeweils durch Laserstrukturierung einer Ätzresistschicht und anschließendes Ätzen erzeugt werden.

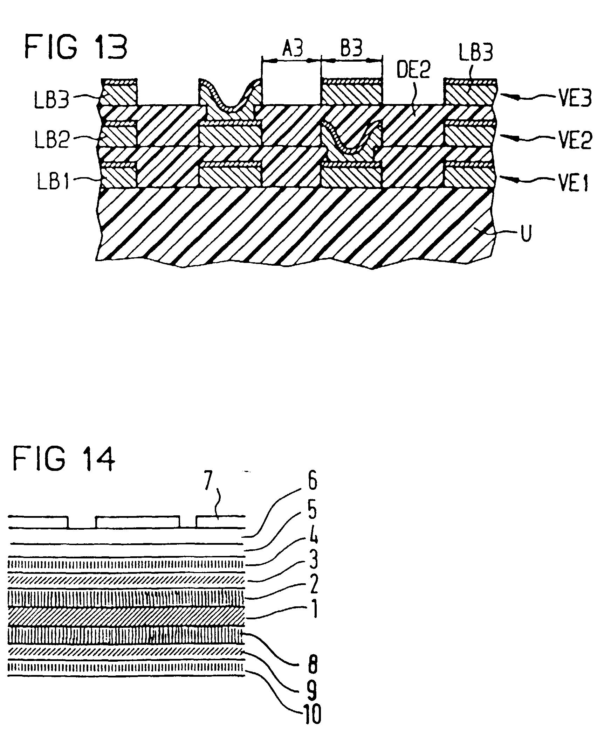

Figur 14 zeigt ebenfalls in stark vereinfachter schematischer Darstellung einen Schnitt durch ein nach dem erfindungsgemäßen Verfahren hergestelltes Multi-Chip-Modul.

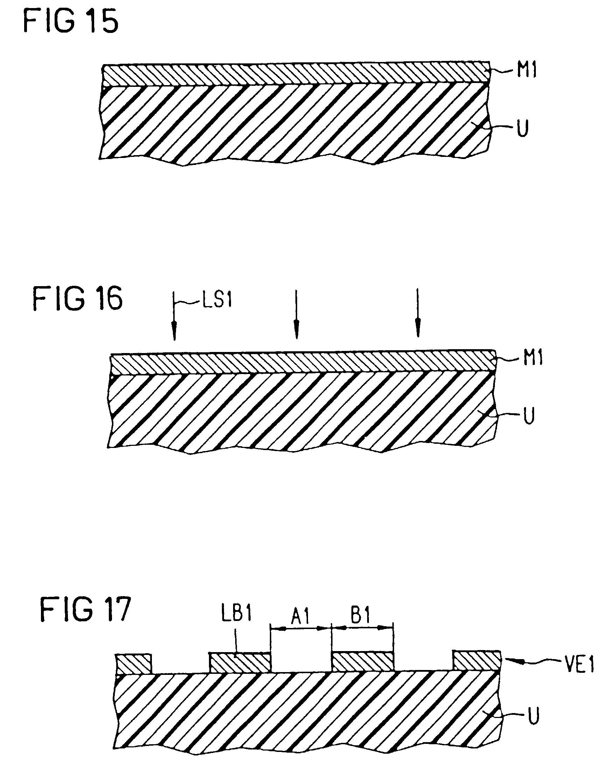

Die Figuren 15 bis 27 zeigen in stark vereinfachter schematischer Darstellung verschiedene Verfahrensstadien bei der Bildung von drei Verdrahtungsebenen auf einer elektrisch isolierenden Unterlage, wobei die einzelnen Verdrahtungsebenen jeweils durch direkte Laserstrukturierung der jeweiligen Metallisierungen erzeugt wurden.

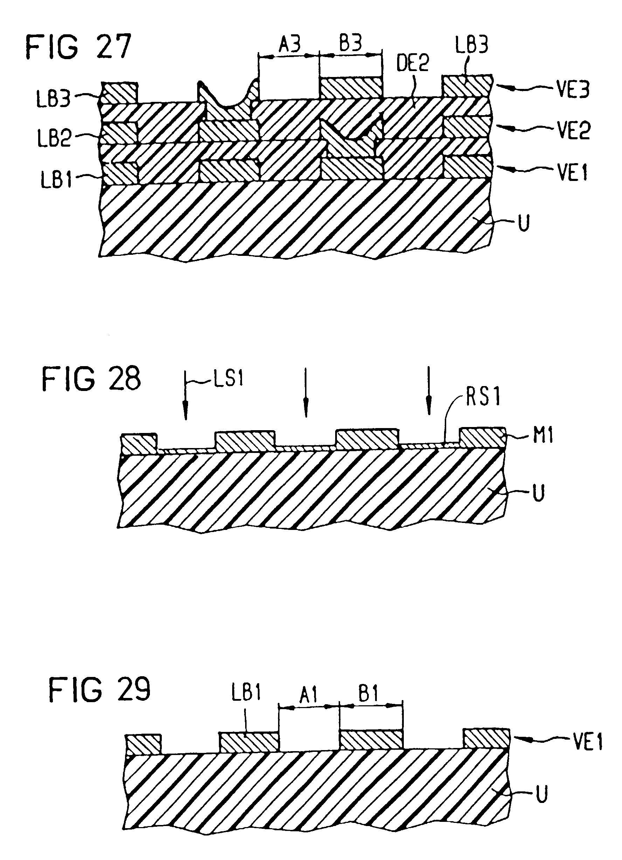

Die Figuren 28 bis 39 zeigen in stark vereinfachter schematischer Darstellung verschiedene Verfahrensstadien bei der Bildung von drei Verdrahtungsebenen auf einer elektrisch isolierenden Unterlage, wobei die einzelnen Verdrahtungsebenen jeweils durch eine nicht ganz vollständige Laserstrukturierung der jeweiligen Metallisierungen erzeugt werden und die im Bereich der Strukturierung verbliebenen dünnen Restschichten der Metallisierungen durch Differenzätzen entfernt werden.

Figur 1 zeigt eine elektrisch isolierende Unterlage U auf welche nacheinander eine erste Metallisierung M1 und eine erste Ätzresistschicht AR1 aufgebracht werden. Bei der Unterlage U kann es sich auch um ein Laminat oder um eine konventionell hergestellte mehrlagige Leiterplatte handeln. Die erste Metallisierung M1 wird durch chemische und galvanische Abscheidung von Kupfer auf die Unterlage U aufgebracht. Die erste Ätzresistschicht AR1 wird im dargestellten Ausführungsbeispiel durch chemische Abscheidung von Zinn auf die erste Metallisierung M1 aufgebracht.

Die erste Ätzresistschicht AR1 wird anschließend gemäß Figur 2 mittels Laserstrahlung LS1 in den unmittelbar an das spätere Leitermuster einer zu erzeugenden ersten Verdrahtungsebene angrenzenden Bereichen wieder entfernt.

Die durch den Laserabtrag gemäß Figur 2 freigelegten Bereiche der ersten Metallisierung M1 werden dann gemäß Figur 3 bis zur Oberfläche der Unterlage U abgeätzt. Durch diesen Strukturierungsvorgang entsteht die bereits erwähnte erste Verdrahtungsebene VE1. Die Leiterbahnen der ersten Verdrahtungsebene VE1 sind mit LB1 bezeichnet, während die konstante Breite dieser Leiterbahnen LB1 mit B1 bezeichnet ist. Der Abstand zwischen den einzelnen Leiterbahnen LB1 ist mit A1 bezeichnet.

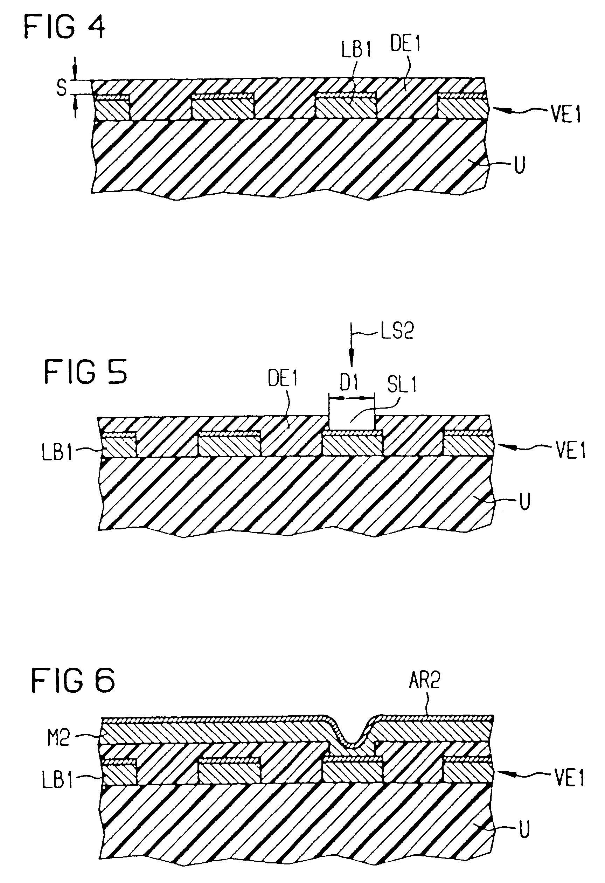

Auf die erste Verdrahtungsebene VE1 wird anschließend gemäß Figur 4 beispielsweise durch Vorhanggießen eine Dielektrikumsschicht DE1 aufgebracht. Die Stärke dieser Dielektrikumsschicht DE1 über den Leiterbahnen LB1 ist mit s bezeichnet.

An den für spätere Durchkontaktierungen vorgesehenen Stellen werden gemäß Figur 5 mittels Laserstrahlung LS2 Sacklöcher SL1 in die erste Dielektrikumsschicht DE1 eingebracht, wobei das dielektrische Material bis zu den Leiterbahnen LB1 der ersten Verdrahtungsebene VE1 abgetragen wird. Die Durchmesser dieser Sacklöcher SL1 sind mit D1 bezeichnet.

Gemäß Figur 6 wird anschließend eine zweite Metallisierung M2 auf die Oberfläche der ersten Dielektrikumsschicht DE1 und die Wandungen der Sacklöcher SL1 aufgebracht. Das Aufbringen der zweiten Metallisierung M2 erfolgt wieder durch chemische und galvanische Abscheidung von Kupfer. Danach wird auf die zweite Metallisierung M2 eine zweite Ätzresistschicht AR2 aufgebracht. Das Aufbringen dieser zweiten Ätzresistschicht AR2 erfolgt auch hier wieder durch chemische Abscheidung von Zinn.

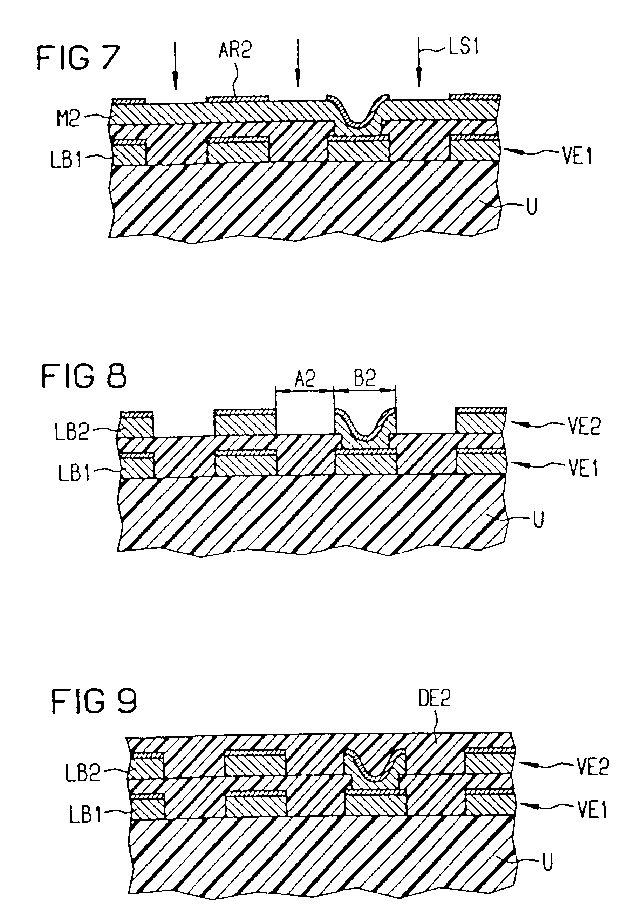

Gemäß Figur 7 wird anschließend die zweite Ätzresistschicht AR2 mittels Laserstrahlung LS1 in den unmittelbar an das spätere Leitermuster einer zu erzeugenden zweiten Verdrahtungsebene angrenzenden Bereichen wieder entfernt.

Die durch den Laserabtrag gemäß Figur 7 freigelegten Bereiche der zweiten Metallisierung M2 werden anschließend bis zur Oberfläche der ersten Dielektrikumsschicht DE1 abgeätzt. Gemäß Figur 8 entsteht bei diesem Strukturierungsvorgang die vorstehend bereits erwähnte zweite Verdrahtungsebene VE2. Die Leiterbahnen dieser zweiten Verdrahtungsebene VE2 sind mit LB2 bezeichnet. Die Breite dieser Leiterbahnen LB2 ist mit B2 bezeichnet, während der Abstand zwischen zwei Leiterbahnen LB2 mit A2 bezeichnet ist.

Auf die aus Figur 8 ersichtliche zweite Verdrahtungsebene VE2 wird anschließend gemäß Figur 9 eine zweite Dielektrikumsschicht DE2 aufgebracht.

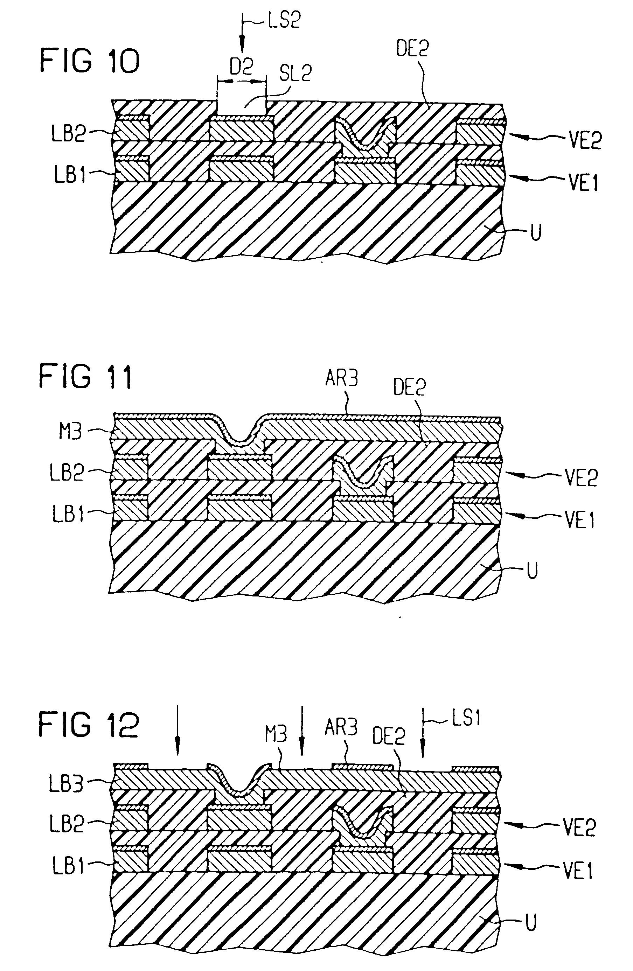

Gemäß Figur 10 werden anschließend an den für Durchkontaktierungen vorgesehenen Stellen mittels Laserstrahlung LS2 Sacklöcher SL2 in die zweite Dielektrikumsschicht DE2 eingebracht.

Nach der Herstellung der Sacklöcher SL2 wird anschließend gemäß Figur 11 auf die Oberfläche der zweiten Dielektrikumsschicht DE2 und die Wandungen der Sacklöcher SL2 eine dritte Metallisierung M3 aufgebracht. Die dritte Metallisierung M3 wird wieder durch die chemische und galvanische Abscheidung von Kupfer erzeugt. Anschließend wird eine dritte Ätzresistschicht AR3 auf die dritte Metallisierung M3 aufgebracht. Das Aufbringen der dritten Ätzresistschicht AR3 erfolgt wieder durch die chemische Abscheidung von Zinn.

Aus Figur 12 ist ersichtlich, daß die dritte Ätzresistschicht AR3 mittels Laserstrahlung LS1 in den unmittelbar an das spätere Leitermuster einer zu erzeugenden dritten Verdrahtungsebene angrenzenden Bereichen wieder entfernt wird.

Die durch den Lasersabtrag gemäß Figur 12 freigelegten Bereiche der dritten Metallisierung M3 werden anschließend bis zur Oberfläche der zweiten Dielektrikumsschicht DE2 abgeätzt. Bei diesem Strukturierungsvorgang entsteht die vorstehend bereits erwähnte dritte Verdrahtungsebene VE3. Die Leiterbahnen der dritten Verdrahtungsebene VE3 sind mit LB3 bezeichnet. Die Breite der Leiterbahnen LB3 ist mit B3 bezeichnet, während der Abstand zwischen den Leiterbahnen LB3 mit A3 bezeichnet ist.

Bei dem in Figur 13 dargestellten Schnitt durch die auf die Unterlage U aufgebrachten Verdrahtungsebenen VE1, VE2 und VE3 verlaufen die einzelnen Leiterbahnen in der gleichen Richtung. Tatsächlich können sich die Leiterbahnen jedoch auch überkreuzen. So ist es beispielsweise denkbar, daß die Leiterbahnen LB1 und LB3 der Verdrahtungsebenen VE1 und VE3 senkrecht zur Zeichnungsebene verlaufen, während die Leiterbahnen LB2 der zweiten Verdrahtungsebene VE2 parallel zur Zeichnungsebene verlaufen.

Bei dem vorstehend anhand der Figuren 1 bis 13 geschilderten Verfahrensablauf wird zur Laserstrukturierung der einzelnen Verdrahtungslage ein diodengepumpter Nd-YAG-Laser verwendet. Zum Einbringen der Sacklöcher in die Dielektrikumsschichten wird ein frequenzverdreifachter Nd-YAG-Laser verwendet.

Figur 14 zeigt in starker vereinfachter schematischer Darstellung einen Multi-Chip-Modul-Aufbau im Schnitt. Bei diesem im folgenden als MCM bezeichneten Multi-Chip-Modul wird von einem elektrisch isolierenden Basismaterial 1 ausgegangen, das ggf. auch mit Widerstandsstrukturen und/oder Kondensatorstrukturen versehen sein kann. Auf dem Basismaterial 1 sind nach oben nacheinander eine Verdrahtungsebene 2 mit Leiterbahnen in X-Richtung, eine Dielektrikumsschicht 3, eine Verdrahtungsebene 4 mit Leiterbahnen in Y-Richtung, eine Dielektrikumsschicht 5, eine als Bausteinanschlußlage ausgebildete Verdrahtungsebene 6 und eine Dielektrikumsschicht 7 ausgebildet. Die mittels Laserstrahlung strukturierte Dielektrikumsschicht 7 erfüllt dabei die Aufgabe eines Lötstopplackes, welcher mit Ausnahme der Bausteinanschlüsse die gesamte Verdrahtungsebene 6 abdeckt. Die Herstellung der Verdrahtungsebene 2, 4 und 6 auuf dem Basismaterial 1 einschließlich der in Figur 14 nicht erkennbaren Durchkontaktierungen erfolgt dabei analog den anhand der Figuren 1 bis 13 beschriebenen Verfahrensschritten.

Nach unten hin sind auf dem Basismaterial 1 nacheinander eine für die Spannungsversorgung vorgesehene Verdrahtungsebene 8, eine Dielektrikumsschicht 9 und eine an Masse gelegte Verdrahtungsebene 10 ausgebildet. Im Gegensatz zu den als Feinstruktur realisierten Verdrahtungsebenen 2, 4 und 6 sind die Verdrahtungsebenen 8 und 10 in konventionaller Technik als Grobstrukturen ausgebildet. Die Verdrahtungsebenen 8 und 10 sind dabei als große Kupferflächen mit Löchern für Durchkontaktierungen ausgebildet. Die Durchkontaktierungen der Verdrahtungsebene 8 und 10 zu den Verdrahtungsebenen 4 und 6 werden mit mechanisch gebohrten Löchern hergestellt, wobei die Durchmesser dieser Löcher 0,3 b is 0,4 mm betragen.

Bei der Herstellung der Verdrahtungsebenen 2, 4 und 6 sowie der Dielektrikumsschichten 3, 5 und 7 erfolgt die Laserbearbeitung pro MCM mit Positionierpunkten oder optischen Justiermarken für jedes MCM. Es wird nicht mehr mit Nutzen- Referenzpunkten gearbeitet, da eine großflächige Positioniereinstellung von mehreren zu einem Nutzen zusammengefaßten MCM's zu ungenauen Positionierungen und gröberen Strukturen bzw. Zu niedrigen Verdrahtungsdichten führen würde. Da die hohen Strukturfeinheiten und vor allem die genaue Positionierung der Verdrahtungsebenen 2 und 4 mit den Strukturierungslagen in X- und Y-Richtung und den Durchkontaktierungen eine kleinflächige Positioniereinstellung erfordern, ist die maximale Fläche für die Laserstrukturierung auf 50 mm x 50 mm beschränkt. Die Bearbeitung kann in Nutzen erfolgen, wobei jedoch eine Laserbearbeitung von Streifen bzw. Bandmaterial bevorzugt wird. Bei der Laserbearbeitung von Streifen bzw. Bandmaterial ist nur noch eine Bewegungsachse mit Feinpositionierung erforderlich, d.h. komplizierte X- und Y- Bewegungssysteme mit Feinpositionierung können entfallen. Bei Anlagen mit zwei Spuren der Streifen oder des Bandmaterials können die Zuführung und Positionierung einer Spur während der Bearbeitung der zweiten Spur erfolgen und umgekehrt.

Die Figuren 15 bis 27 zeigen verschiedene Verfahrensstadien einer ersten Variante des anhand der Figuren 1 bis 13 beschriebenen Verfahrens.

Bei dieser ersten Variante wird gemäß Figur 15 von einer elektrisch isolierenden Unterlage U ausgegangen, auf welche eine erste Metallisierung M1 aufgebracht wird.

Die erste Metallisierung M1 wird anschließend gemäß Figur 16 mittels Laserstrahlung LS1 in den unmittelbar an das spätere Leitermuster einer zu erzeugenden ersten Verdrahtungsebene angrenzenden Bereichen wieder entfernt.

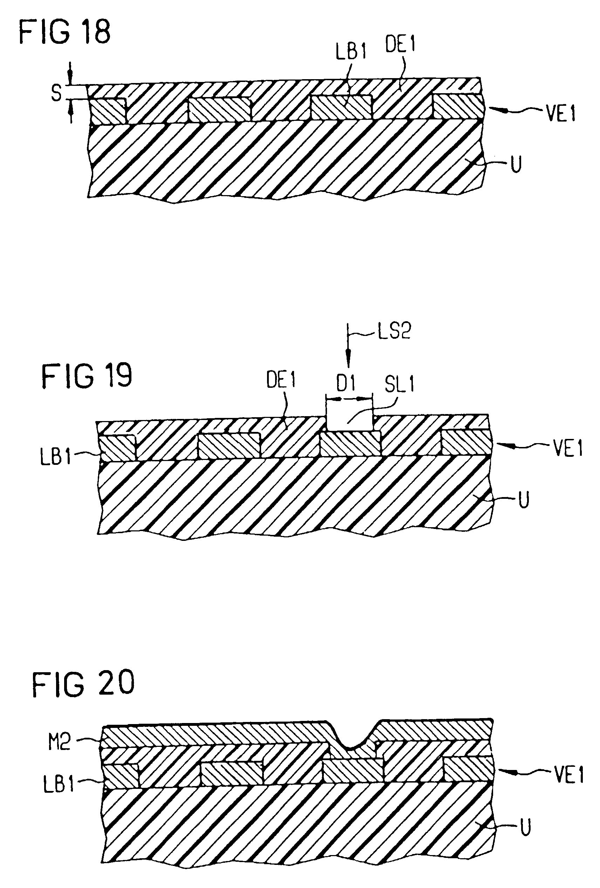

Durch den Laserabtrag gemäß Figur 16 entsteht gemäß Figur 17 die erste Verdrahtungsebene VE1. Analog zu der Figur 3 sind die Leiterbahnen der ersten Verdrahtungsebene VE1 mit LB1 bezeichnet, während die konstante Breite dieser Leiterbahnen LB1 mit B1 bezeichnet ist. Die folgenden aus den Figuren 18 bis 20 ersichtlichen Verfahrensschritte entsprechen den anhand der Figuren 4 bis 6 beschriebenen Verfahrensschritten, wobei jedoch die Aufbringung einer Ätzresistschicht auf die zweite Metallisierung M2 unterbleibt.

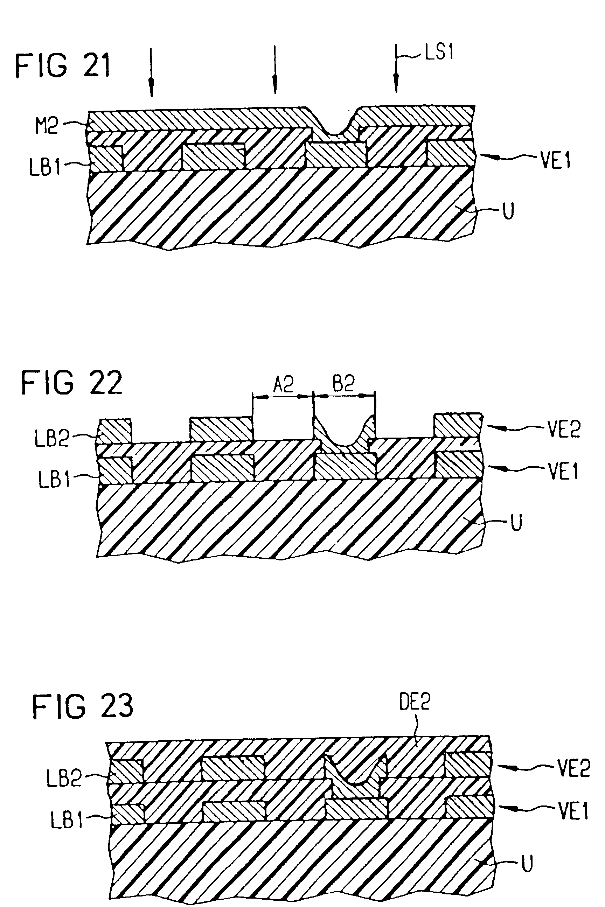

Gemäß Figur 21 wird die zweite Metallisierung M2 mittels Laserstrahlung LS1 in den unmittelbar an das spätere Leitermuster einer zu erzeugenden zweiten Verdrahtungsebene angrenzenden Bereichen wieder entfernt.

Durch den Laserabtrag gemäß Figur 21 entsteht gemäß Figur 22 die zweite Verdrahtungsebene VE2. Analog zu der Figur 8 sind die Leiterbahnen der zweiten Verdrahtungsebene VE2 mit LB2 bezeichnet. Die Breite dieser Leiterbahnen LB2 ist mit B2 bezeichnet, während der Abstand zwischen zwei Leiterbahnen LB2 mit A2 bezeichnet ist.

Die folgenden aus den Figuren 23 bis 25 ersichtlichen Verfahrensschritte entsprechen den anhand der Figuren 9 bis 11 beschriebenen Verfahrensschritten, wobei jedoch die Aufbringung einer Ätzresistschicht auf die dritte Metallisierung M3 unterbleibt.

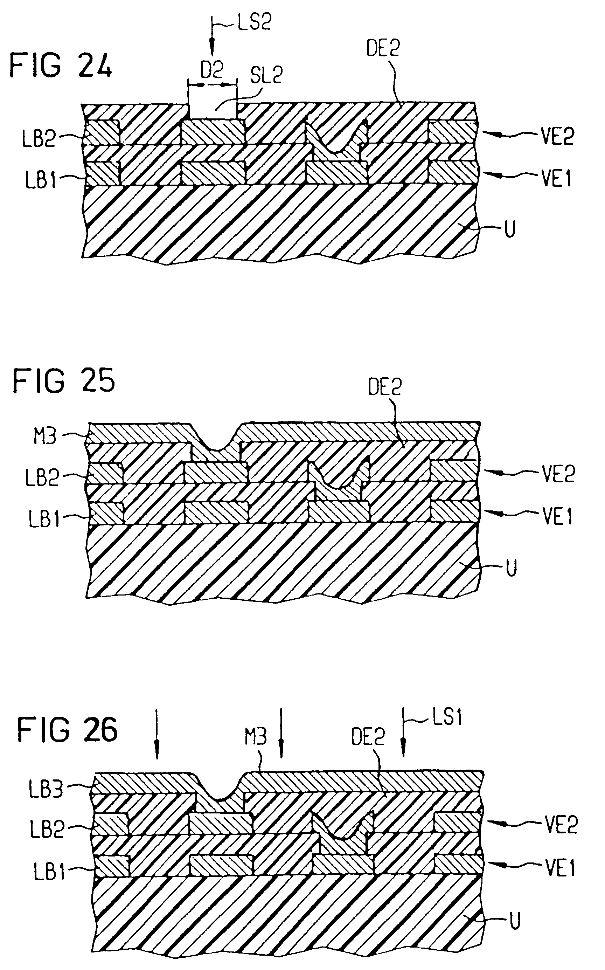

Gemäß Figur 26 wird die dritte Metallisierung M3 mittels Laserstrahlung LS1 in den unmittelbar an das spätere Leitermuster einer zu erzeugenden dritten Verdrahtungsebene angrenzenden Bereichen wieder entfernt.

Durch den Laserabtrag gemäß Figur 26 entsteht gemäß Figur 27 die dritte Verdrahtungsebene VE3. Analog zu der Figur 13 sind die Leiterbahnen der dritten Verdrahtungsebene VE3 mit LB3 bezeichhnet. Die Breite der Leiterbahnen LB3 ist mit B3 bezeichnet, während der Abstand zwischen den Leiterbahnen LB3 mit A3 bezeichnet ist.

Die Figuren 28 bis 39 zeigen verschiedene Verfahrensstadien einer zweiten Variante des anhand der Figuren 1 bis 13 beschriebenen Verfahrens. Die zweite Variante unterscheidet sich von der ersten Variante zunächst dadurch, daß gemäß Figgur 28 bei der Strukturierung der ersten Metallisierung M1 mittels Laserstrahlung LS1 das Metall nur bis dicht oberhalb der Oberfläche der Unterlage U abgetragen wird. Die verbliebene dünne Restschicht RS1 wird dann anschließend durch Differenzätzen bis zur Oberfläche der Unterlage U abgetragen, wobei gemäß Figur 29 die erste Verdrahtungsebene VE1 entsteht. Bei den Differenzätzen wird das gesamte in Figur 28 dargestellte Gebilde in eine Ätzlösung eingetaucht, welche nicht nur die Restschicht RS1, sondern auch die übrige Metallisierung M1 angreift. Da die Restschicht RS1 sehr dünn ist und die Ätzzeit entsprechend kurz bemessen ist, hat der Ätzangriff auf die übrige Metallisierung M1 keine nachteiligen Folgen.

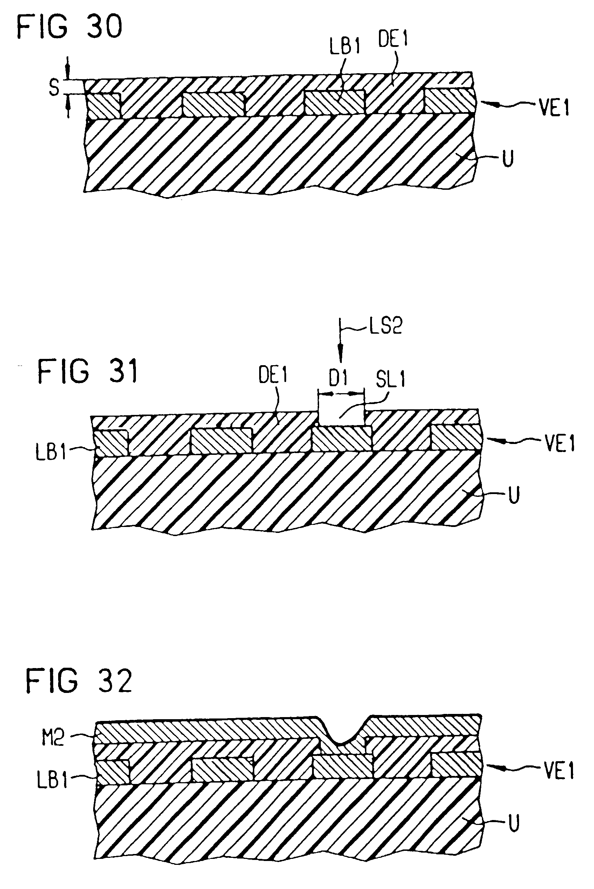

Die folgenden aus den Figuren 30 bis 32 ersichtlichen Verfahrensschritte entsprechen den anhand der Figuren 18 bis 20 beschriebenen Verfahrensschritten.

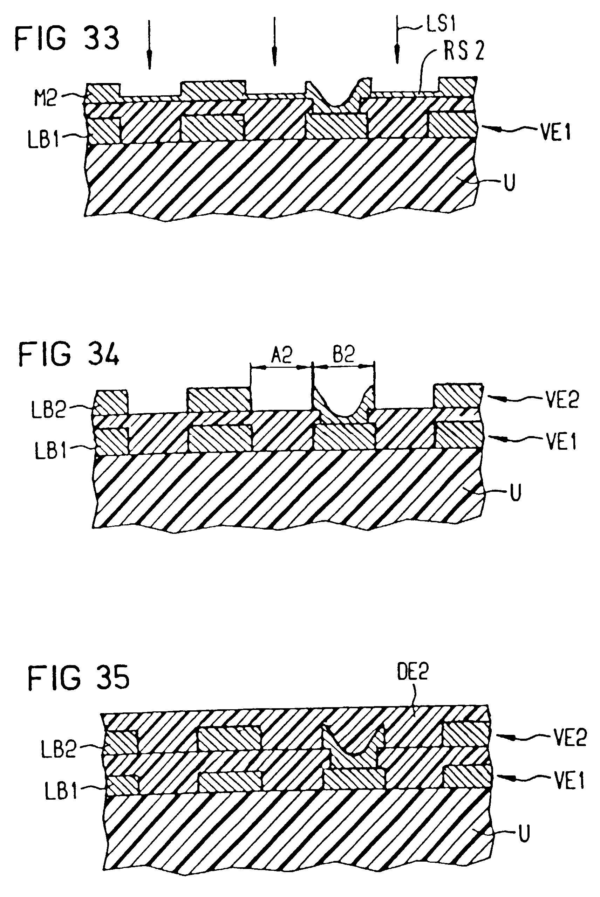

Gemäß Figur 33 wird die zweite Metallisierung M2 mittels Laserstrahlung LS1 nur bis dicht oberhalb der Oberfläche der Dielektrikumsschicht DE1 abgetragen. Die verbliebene dünne Restschicht RS2 wird dann anschließend durch Differenzätzen bis zur Oberfläche der Dielektrikumsschicht DE1 abgetragen, wobei gemäß Figur 34 die zweite Verdrahtungsebene VE2 entsteht.

Die folgenden aus den Figuren 35 bis 37 ersichtlichen Verfahrensschritte entsprechen den anhand der Figuren 23 bis 25 beschriebenen Verfahrensschritten.

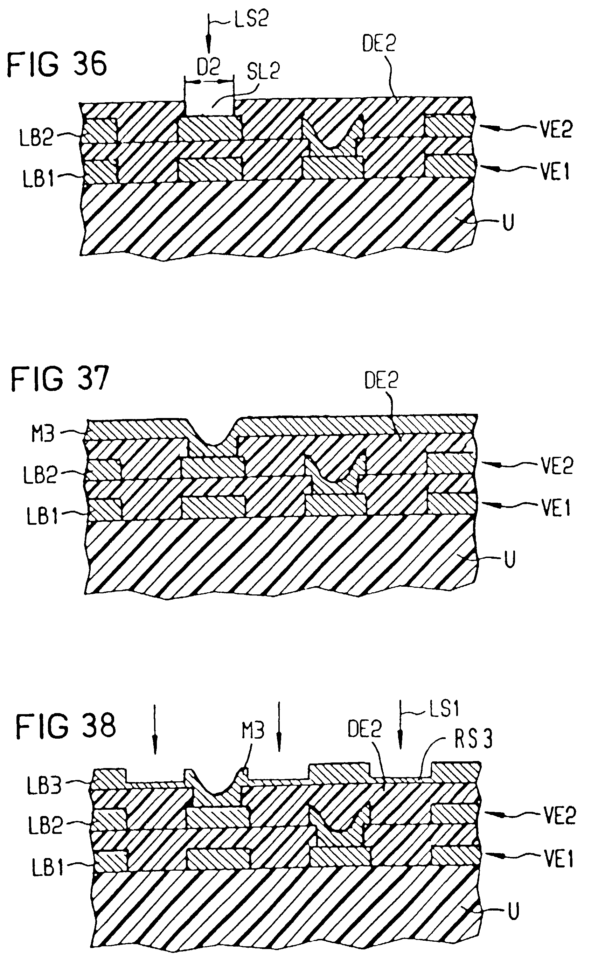

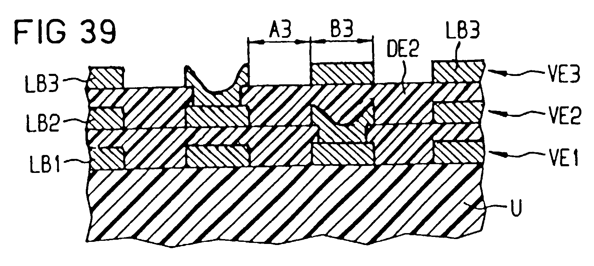

Gemäß Figur 38 wird die dritte Metallisierung M3 mittels Laserstrahlung LS1 nur bis dicht oberhalb der Oberfläche der zweiten Dielektrikumsschicht DE2 abgetragen. Die verbliebene dünne Restschicht RS3 wird dann anschließend durch Differenzätzen bis zur Oberfläche der Dielektrikumsschicht DE2 abgetragen, wobei gemäß Figur 39 die dritte Verdrahtungsebene VE3 entsteht.

## Patentansprüche

1. Verfahren zur Bildung von mindestens zwei Verdrahtungsebenen (VE1, VE2) auf elektrisch isolierenden Unterlagen (U), mit folgenden Verfahrensschritten:
a) Aufbringen einer ersten Metallisierung (Ml) auf die Unterlage (U);
b) Entfernen der ersten Metallisierung (Ml) mittels Laserstrahlung (LS1) zumindest in den unmittelbar an das spätere Leitermuster der ersten Verdrahtungsebene (VE1) angrenzenden Bereichen und zumindest weitgehend bis zur Oberfläche der Unterlage (U);
c) Aufbringen einer Dielektrikumsschicht (DE1) auf die im Verfahrensschritt b) gebildete erste Verdrahtungsebene (VE1);
d) Einbringen von Sacklöchern (SL1) in die Dielektrikumsschicht (DE1) mittels Laserstrahlung (LS2), wobei das dielektrische Material bis zu den Leiterbahnen (LB1) der ersten Verdrahtungsebene (VE1) abgetragen wird,
e) Aufbringen einer zweiten Metallisierung (M2) auf die Oberfläche der Dielektrikumsschicht (DE1) und die Wandungen der Sacklöcher (SL1);
f) Entfernen der zweiten Metallisierung (M2) mittels Laserstrahlung (LS1) zumindest in den unmittelbar an das spätere Leitermuster der zweiten Verdrahtungsebene (VE2) angrenzenden Bereichen, und zumindest weitgehend bis zur Oberfläche der Dielektrikumsschicht (DE1);
wobei im Verfahrensschritt b) eine Kontur des Leitermusters der ersten Verdrahtungsebene (VE1) vorgegeben wird, bei welcher die Leiterbahnen (LB1) auch im Bereich der später im Verfahrensschritt d) zu erzeugenden Sacklöcher (SL1) eine konstante Breite (Bl) aufweisen.

2. Verfahren nach Anspruch 1,
**gekennzeichnet durch** folgende weitere Verfahrensschritte:
g) Aufbringen einer zweiten Dielektrikumsschicht (DE2) auf die im Verfahrensschritt f) gebildete zweite Verdrahtungsebene ((VE2);
h) Einbringen von Sacklöchern (SL2) in die zweite Dielektrikumsschicht (DE2) mittels Laserstrahlung (LS2), wobei das dielektrische Material bis zu den Leiterbahnen (LB2) der zweiten Verdrahtungsebene (VE2) abgetragen wird;
i) Aufbringen einer dritten Metallisierung (M3) auf die Oberfläche der zweiten Dielektrikumsschicht (DE2) und die Wandungen der Sacklöcher (SL2);
j) Entfernen der dritten Metallisierung (M3) mittels Laserstrahlung (LS1) zumindest in den unmittelbar an das spätere Leitermuster der dritten Verdrahtungsebenen (VE3) angrenzenden Bereichen und zumindest weitgehend bis zur Oberfläche der zweiten Dielektrikumsschicht (DE2);
wobei im Verfahrensschritt f) eine Kontur des Leitermusters der zweiten Verdrahtungsebene (VE2) vorgegeben wird, bei welcher die Leiterbahnen (LB2) auch im Bereich der später im Verfahrensschritt h) zu erzeugenden Sacklöcher (SL2) eine konstante Breite (B2) aufweisen.

3. Verfahren nach Anspruch 1 oder 2,
dadurch **gekennzeichnet**,
daß im Verfahrensschritt b) die erste Metallisierung (M1) bis dicht oberhalb der Oberfläche der Unterlage (U) abgetragen wird und daß die verbliebene Restschicht (RS1) durch Differenzätzen bis zur Oberfläche der Unterlage (U) abgetragen wird.

4. Verfahren nach einem der Ansprüche 1 bis 3,
dadurch **gekennzeichnet**,
daß im Verfahrensschritt f) die zweite Metallisierung (M2) bis dicht oberhalb der Oberfläche der Dielektrikumsschicht (DE1) abgetragen wird und daß die verbliebene Restschicht (RS2) durch Differenzätzen bis zur Oberfläche der Dielektrikumsschicht (DE1) abgetragen wird.

5. Verfahren nach einem der Ansprüche 2 bis 4,
dadurch **gekennzeichnet**,
daß im Verfahrensschritt j) die dritte Metallisierung (M3) bis dicht oberhalb der Oberfläche der zweiten Dielektrikumsschicht (DE2) abgetragen wird und daß die verbliebene Restschicht (RS3) durch Differenzätzen bis zur Oberfläche der zweiten Dielektrikumsschicht (DE2) abgetragen wird.

6. Verfahren zur Bildung von mindestens zwei Verdrahtungsebenen (VE1, VE2) auf elektrisch isolierenden Unterlagen (U), mit folgenden Verfahrensschritten:
a) Aufbringen einer ersten Metallisierung (M1) auf die Unterlage (U);
b) Aufbringen einer ersten Ätzresistschicht (AR1) auf die erste Metallisierung (M1);
c) Entfernen der ersten Ätzresistschicht (AR1) mittels Laserstrahlung (LS1) zumindest in den unmittelbar an das spätere Leitermuster der ersten Verdrahtungsebene (VE1) angrenzenden Bereichen;
d) Abätzen der im Verfahrensschritt c) freigelegten Bereiche der ersten Metallisierung (M1) bis zur Oberfläche der Unterlage (U);
e) Aufbringen einer Dielektrikumsschicht (DE1) auf die im Verfahrensschritt d) gebildete erste Verdrahtungsebene (VE1);
f) Einbringen von Sacklöchern (SL1) in die Dielektrikumsschicht (DE1) mittels Laserstrahlung (LS2), wobei das dielektrische Material bis zu den Leiterbahnen (LB1) der ersten Verdrahtungsebene (VE1) abgetragen wird,
g) Aufbringen einer zweiten Metallisierung (M2) auf die Oberfläche der Dielektrikumsschicht (DE1) und die Wandungen der Sacklöcher (SL1);
h) Aufbringen einer zweiten Ätzresistschicht (AR2) auff die zweite Metallisierung (M2);
i) Entfernen der zweiten Ätzresistschicht (AR2) mittels Laserstrahlung (LS1) zumindest in den unmittelbar an das spätere Leitermuster der zweiten Verdrahtungsebene (VE2) angrenzenden Bereichen;
j) Abätzen der im Schritt i) freigelegten Bereiche der zweiten Metallisierung (M2) bis zur Oberfläche der Dielektrikumsschicht (DE1);
wobei im Verfahrensschritt c) eine Kontur des Leitermusters der ersten Verdrahtungsebene (VE1) vorgegeben wird, bei welcher die Leiterbahnen (LB1) auch im Bereich der später im Verfahrensschritt f) zu erzeugenden Sacklöcher (SL1) eine konstante Breite (B1) aufweisen.

7. Verfahren nach Anspruch 6,
**gekennzeichnet durch** folgende weitere Verfahrensschritte:
k) Aufbringen einer zweiten Dielektrikumsschicht (DE2) auf die im Verfahrensschritt j) gebildete zweite Verdrahtungsebene ((VE2);
l) Einbringen von Sacklöchern (SL2) in die zweite Dielektrikumsschicht (DE2) mittels Laserstrahlung (LS2), wobei das dielektrische Material bis zu den Leiterbahnen (LB2) der zweiten Verdrahtungsebene (VE2) abgetragen wird;
m) Aufbringen einer dritten Metallisierung (M3) auf die Oberfläche der zweiten Dielektrikumsschicht (DE2) und die Wandungen der Sacklöcher (SL2);
n) Aufbringen einer dritten Ätzresistschicht (AR3) auf die dritte Metallisierung (M3);
o) Entfernen der dritten Ätzresistschicht (AR3) mittels Laserstrahlung (LS1) zumindest in den unmittelbar an das spätere Leitermuster der dritten Verdrahtungsebenen (VE3) angrenzenden Bereichen;
p)Abätzen der im Schritt o) freigelegten Bereiche der dritten Metallisierung (M3) bis zur Oberfläche der zweiten Dielektrikumsschicht (DE2);
wobei im Verfahrensschritt i) eine Kontur des Leitermusters der ersten Verdrahtungsebene (VE2) vorgegeben wird, bei welcher die Leiterbahnen (LB2) auch im Bereich der später im Verfahrensschritt l) zu erzeugenden Sacklöcher (SL2) eine konstante Breite (B2) aufweisen.

8. Verfahren nach einem der vorhergehenden Ansprüche,
**dadurch gekennzeichnet,**
daß die Metallisierung (M1; M2; M3) durch stromlose und galvanische Abscheidung von Kupfer aufgebracht wird.

9. Verfahren nach einem der Ansprüche 6 bis 8,
**dadurch gekennzeichnet,**
daß die Ätzresistschicht (AR1; AR2; AR3) durch chemische Abscheidung von Zinn aufgebracht wird.

10. Verfahren nach einem der Ansprüche 6 bis 9,
**dadurch gekennzeichnet,**
daß die partielle Entfernung der Ätzresistschicht (AR1; AR2; AR3) mittels Laserstrahlung (LS1) mit einem ablenkbaren Strahl vorgenommen wird.

11. Verfahren nach einem der vorhergehenden Ansprüche,
**gekennzeichnet durch**
die maskenlose Erzeugung der Sacklöcher (SL1; SL2) mit Hilfe eines fokussierten Laserstrahls.

12. Verfahren nach einem der vorhergehenden Ansprüche,
**dadurch gekennzeichnet,**
daß die Leitermuster der Verdrahtungsebenen (VE1; VE2; VE3) auf eine Fläche von maximal 50 mm x 50 mm begrenzt werden.

13. Verfahren nach Anspruch 12,
**dadurch gekennzeichnet,**
daß in den Verdrahtungsebenen (VE1; VE2; VE3) Leiterbahnen (LB1; LB2; LB3) mit einer Breite (B1; B2; B3) von maximal 75 µm erzeugt werden.

14. Verfahren nach Anspruch 12 oder 13,
**dadurch gekennzeichnet,**
daß Sacklöcher (SL1; SL2) mit einem Durchmesser (D1; D2) von maximal 55 µm erzeugt werden.

15. Verfahren nach einem der Ansprüche 12 bis 14,
**dadurch gekennzeichnet,**
daß in den Verdrahtungsebenen (VE1; VE2; VE3) Leitermuster mit einem Abstand (A1; A2; A3) zwischen den Leiterbahnen (LB1; LB2; LB3) von maximal 40 µm erzeugt werden.

16. Verfahren nach einem der Ansprüche 12 bis 15,
**dadurch gekennzeichnet,**
daß Metallisierungen (M1; M2; M3) mit einer Stärke von maximal 10 µm aufgebracht werden.

17. Verfahren nach einem der Ansprüche 12 bis 16,
**dadurch gekennzeichnet,**
daß Dielektrikumsschichten (DE1; DE2) mit einer Stärke (s) von maximal 40 µm aufgebracht werden.

18. Verfahren nach einem der Ansprüche 1 bis 6,
**dadurch gekennzeichnet,**
daß die Leitermuster der Verdrahtungsebenen (VE1; VE2; VE3) auf eine Fläche von maximal 25 mm x 25 mm begrenzt werden.

19. Verfahren nach Anspruch 18,
**dadurch gekennzeichnet,**
daß in den Verdrahtungsebenen (VE1; VE2; VE3) Leiterbahnen (LB1; LB2; LB3) mit einer Breite (B1; B2; B3) von maximal 50 um erzeugt werden.

20. Verfahren nach Anspruch 18 oder 19,
**dadurch gekennzeichnet,**
daß Sacklöcher (SL1; SL2) mit einem Durchmesser (D1; D2) von maximal 35 um erzeugt werden.

21. Verfahren nach einem der Ansprüche 18 bis 20,
**dadurch gekennzeichnet,**
daß in den Verdrahtungsebenen (VE1; VE2; VE3) Leitermuster mit einem Abstand (A1; A2; A3) zwischen den Leiterbahnen (LB1; LB2; LB3) von maximal 35 um erzeugt werden.

22. Verfahren nach einem der Ansprüche 18 bis 21,
**dadurch gekennzeichnet,**
daß Metallisierungen (M1; M3; M3) mit einer Stärke von maximal 5 um aufgebracht werden.

23. Verfahren nach einem der Ansprüche 18 bis 22,
**dadurch gekennzeichnet,**
daß Dielektrikumsschichten (DE1; DE2) mit einer Stärke (s) von maximal 25 um aufgebracht werden.

## Claims

1. Process for forming at least two interconnect planes (VE1, VE2) on electrically insulating substrates (U), having the following process steps:
a) applying a first metallization (M1) on the substrate (U);
b) removing the first metallization (M1) using laser radiation (LS1) at least in the areas directly adjoining the future conductor pattern of the first interconnect plane (VE1), and at least substantially as far as the surface of the substrate (U);
c) applying a dielectric layer (DE1) on the first interconnect plane (VE1) formed in process step b);
d) making blind holes (SL1) in the dielectric layer (DE1) using laser radiation (LS2), the dielectric material being removed as far as the interconnects (LB1) of the first interconnect plane (VE1),
e) applying a second metallization (M2) on the surface of the dielectric layer (DE1) and the walls of the blind holes (SL1);
f) removing the second metallization (M2) using laser radiation (LS1) at least in the areas directly adjoining the future conductor pattern of the second interconnect plane (VE2), and at least substantially as far as the surface of the dielectric layer (DE1);
a contour of the conductor pattern of the first interconnect plane (VE1) being defined in process step b) in which the interconnects (LB1) have a constant width (B1) even in the area of the blind holes (SL1) that are to be produced subsequently in process step d).

2. Process according to Claim 1, characterized by the following further process steps:
g) applying a second dielectric layer (DE2) on the second interconnect plane (VE2) formed in process step f);
h) making blind holes (SL2) in the second dielectric layer (DE2) using laser radiation (LS2), the dielectric material being removed as far as the interconnects (LB2) of the second interconnect plane (VE2);
i) applying a third metallization (M3) on the surface of the second dielectric layer (DE2) and the walls of the blind holes (SL2);
j) removing the third metallization (M3) using laser radiation (LS1) at least in the areas directly adjoining the future conductor pattern of the third interconnect planes (VE3), and at least substantially as far as the surface of the second dielectric layer (DE2);
a contour of the conductor pattern of the second interconnect plane (VE2) being defined in process step f) in which the interconnects (LB2) have a constant width (B2) even in the area of the blind holes (SL2) that are to be produced subsequently in process step h).

3. Process according to Claim 1 or 2, characterized in that in process step b) the first metallization (M1) is removed to just above the surface of the substrate (U), and in that the remaining residual layer (RS1) is removed by differential etching as far as the surface of the substrate (U).

4. Process according to one of Claims 1 to 3, characterized in that in process step f) the second metallization (M2) is removed to just above the surface of the dielectric layer (DE1), and in that the remaining residual layer (RS2) is removed by differential etching as far as the surface of the dielectric layer (DE1).

5. Process according to one of Claims 2 to 4, characterized in that in process step j) the third metallization (M3) is removed to just above the surface of the second dielectric layer (DE2), and in that the remaining residual layer (RS3) is removed by differential etching as far as the surface of the second dielectric layer (DE2).

6. Process for forming at least two interconnect planes (VE1, VE2) on electrically insulating substrates (U), having the following process steps:
a) applying a first metallization (M1) on the substrate (U);
b) applying a first etch resist layer (AR1) on the first metallization (M1);
c) removing the first etch resist layer (AR1) using laser radiation (LS1) at least in the areas directly adjoining the future conductor pattern of the first interconnect plane (VE1);
d) etching off the areas of the first metallization (M1) that are exposed in process step c) as far as the surface of the substrate (U);
e) applying a dielectric layer (DE1) on the first interconnect plane (VE1) formed in process step d);
f) making blind holes (SL1) in the dielectric layer (DE1) using laser radiation (LS2), the dielectric material being removed as far as the interconnects (LB1) of the first interconnect plane (VE1),
g) applying a second metallization (M2) on the surface of the dielectric layer (DE1) and the walls of the blind holes (SL1);
h) applying a second etch resist layer (AR2) on the second metallization (M2);
i) removing the second etch resist layer (AR2) using laser radiation (LS1) at least in the areas directly adjoining the future conductor pattern of the second interconnect plane (VE2);
j) etching off the areas of the second metallization (M2) that have been exposed in step i) as far as the surface of the dielectric layer (DE1);
a contour of the conductor pattern of the first interconnect plane (VE1) being defined in process step c) in which the interconnects (LB1) have a constant width (B1) even in the area of the blind holes (SL1) that are to be produced subsequently in process step f).

7. Process according to Claim 6, characterized by the following further process steps:
k) applying a second dielectric layer (DE2) on the second interconnect plane (VE2) formed in process step j);
l) making blind holes (SL2) in the second dielectric layer (DE2) using laser radiation (LS2), the dielectric material being removed as far as the interconnects (LB2) of the second interconnect plane (VE2);
m) applying a third metallization (M3) on the surface of the second dielectric layer (DE2) and the walls of the blind holes (SL2);
n) applying a third etch resist layer (AR3) on the third metallization (M3);
o) removing the third etch resist layer (AR3) using laser radiation (LS1) at least in the areas directly adjoining the future conductor pattern of the third interconnect planes (VE3);
p) etching off the areas of the third metallization (M3) that have been exposed in step o) as far as the surface of the second dielectric layer (DE2);
a contour of the conductor pattern of the first interconnect plane (VE2) being defined in process step i) in which the interconnects (LB2) have a constant width (B2) even in the area of the blind holes (SL2) that are to be produced subsequently in process step 1).

8. Process according to one of the preceding claims, characterized in that the metallization (M1; M2; M3) is applied by electroless and electrolytic deposition of copper.

9. Process according to one of Claims 6 to 8, characterized in that the etch resist layer (AR1; AR2; AR3) is applied by chemical deposition of tin.

10. Process according to one of Claims 6 to 9, characterized in that the partial removal of the etch resist layer (AR1; AR2; AR3) using laser radiation (LS1) is carried out using a deflectable beam.

11. Process according to one of the preceding claims, characterized by maskless production of the blind holes (SL1; SL2) using a focused laser beam.

12. Process according to one of the preceding claims, characterized in that the conductor patterns of the interconnect planes (VE1; VE2; VE3) are restricted to an area of at most 50 mm x 50 mm.

13. Process according to Claim 12, characterized in that interconnects (LB1; LB2; LB3) having a width (B1; B2; B3) of at most 75 µm are produced in the interconnect planes (VE1; VE2; VE3).

14. Process according to Claim 12 or 13, characterized in that blind holes (SL1; SL2) with a diameter (D1; D2) of at most 55 µm are produced.

15. Process according to one of Claims 12 to 14, characterized in that conductor patterns with a spacing (Al; A2; A3) between the interconnects (LB1; LB2; LB3) of at most 40 µm are produced in the interconnect planes (VE1; VE2; VE3).

16. Process according to one of Claims 12 to 15, characterized in that metallizations (M1; M2; M3) are applied with a thickness of at most 10 µm.

17. Process according to one of Claims 12 to 16, characterized in that dielectric layers (DE1; DE2) with a thickness (s) of at most 40 µm are applied.

18. Process according to one of Claims 1 to 6, characterized in that the conductor patterns of the interconnect planes (VE1; VE2; VE3) are restricted to an area of at most 25 mm × 25 mm.

19. Process according to Claim 18, characterized in that interconnects (LB1; LB2; LB3) having a width (B1; B2; B3) of at most 50 µm are produced in the interconnect planes (VE1; VE2; VE3).

20. Process according to Claim 18 or 19, characterized in that blind holes (SL1; SL2) with a diameter (D1; D2) of at most 35 µm are produced.

21. Process according to one of Claims 18 to 20, characterized in that conductor patterns with a spacing (A1; A2; A3) between the interconnects (LB1; LB2; LB3) of at most 35 µm are produced in the interconnect planes (VE1; VE2; VE3).

22. Process according to one of Claims 18 to 21, characterized in that metallizations (M1; M2; M3) are applied with a thickness of at most 5 µm.

23. Process according to one of Claims 18 to 22, characterized in that dielectric layers (DE1; DE2) with a thickness (s) of at most 25 µm are applied.

## Revendications

1. Procédé pour former au moins deux niveaux (VE1, VE2) de câblage sur des supports (U) isolants du point de vue électrique, comportant les étapes opératoires suivantes :
a) on dépose une première métallisation (M1) sur le support (U);
b) on enlève la première métallisation (M1) au moyen d'un faisceau (LS1) laser au moins dans les zones directement adjacentes au dessin futur du chemin des conducteurs du premier niveau (VE1) de câblage et au moins dans une grande mesure jusqu'à la surface du support (U) ;
c) on dépose une couche (DE1) de diélectrique sur le premier niveau (VE1) de câblage formé à l'étape opératoire b);
d) on ménage des trous (LS1) borgnes dans la couche (DE1) de diélectrique au moyen d'un faisceau (LS) de laser, le matériau diélectrique étant enlevé jusqu'aux pistes (LB1) du premier niveau (VE1) de câblage ;
e) on dépose une deuxième métallisation (M2) à la surface de la couche (DE1) diélectrique et sur les parois des trous (SL1) borgnes ;
f) on enlève la deuxième métallisation (M2) au moyen d'un faisceau (LS1) laser au moins dans les zones directement adjacentes au dessin futur du chemin des conducteurs du deuxième niveau (VE2) de câblage et au moins dans une grande mesure jusqu'à la surface de la couche (DE1) de diélectrique;
un contour du dessin des conducteurs du premier niveau (VE1) de câblage étant donné à l'étape b), dans lequel les pistes (LB1) conductrices comportent une largeur (B1) constante aussi dans la zone des trous (SL1) borgnes à produire ultérieurement à l'étape d) opératoire.

2. Procédé suivant la revendication 1, caractérisé par les étapes opératoires supplémentaires suivantes :
g) on dépose une deuxième couche (DE2) diélectrique sur le deuxième niveau (VE2) de câblage formé à l'étape f) opératoire ;
h) on ménage des trous (SL2) borgnes dans la deuxième couche (DE2) diélectrique au moyen d'un faisceau (LS2) laser, le matériau diélectrique étant enlevé jusqu'aux pistes (LB2) conductrices du deuxième niveau (VE2) de câblage ;
i) on dépose une troisième métallisation (M3) à la surface de la deuxième couche (DE2) de diélectrique et sur les parois des trous (SL2) borgnes ;
j) on enlève la troisième métallisation (M3) au moyen d'un faisceau (LS1) laser au moins dans les zones directement adjacentes au dessin futur du chemin des conducteurs du troisième niveau (VE3) de câblage et au moins dans une grande mesure jusqu'à la surface de la deuxième couche (DE2) diélectrique ;
un contour du dessin du chemin des conducteurs du deuxième niveau (VE2) de câblage étant prescrit à l'étape f) opératoire, dans lequel les pistes (LB2) conductrices comportent une largeur (B2) constante aussi dans la région des trous (SL2) borgnes à produire ultérieurement à l'étape h) opératoire.

3. Procédé suivant la revendication 1 ou 2, caractérisé en ce que, à l'étape b) opératoire, on enlève la première métallisation (M1) jusque tout juste au dessus de la surface du support (U) et en ce que l'on enlève la couche (RS1) résiduelle restante jusqu'à la surface du support (U) par attaque chimique différentielle.

4. Procédé suivant l'une des revendications 1 à 3, caractérisé en ce que, à l'étape f) opératoire, on enlève la deuxième métallisation (M2) jusque tout juste au dessus de la surface de la couche (DE1) diélectrique et en ce que l'on enlève la couche (RS2) résiduelle restante par attaque chimique différentielle jusqu'à la surface de la couche (DE1) de diélectrique.

5. Procédé suivant l'une des revendications 2 à 4, caractérisé en ce que, à l'étape j) opératoire, on enlève la troisième métallisation (M3) jusque tout juste au dessus de la surface de la deuxième couche (DE2) diélectrique et en ce que l'on enlève la couche (RS3) résiduelle restante par attaque chimique différentielle jusqu'à la surface de la deuxième couche (DE2) de diélectrique.

6. Procédé pour former au moins deux niveaux (VE1, VE2) de câblage sur des supports (U) isolants du point de vue électrique, comportant les étapes opératoires suivantes :
a) on dépose une première métallisation (M1) sur le support (U) ;
b) on dépose une première couche (AR1) résistante à l'attaque chimique sur la première métallisation (M1);
c) on enlève la première couche (AR1) résistante à l'attaque chimique au moyen d'un faisceau (LS1) laser au moins dans les zones directement adjacentes au dessin futur du chemin des conducteurs du premier niveau (VE1) de câblage ;
d) on enlève par attaque chimique jusqu'à la surface du support (U) les zones de la première métallisation (M1) dégagées à l'étape c) opératoire ;
e) on dépose une couche (DE1) de diélectrique sur le premier niveau (VE1) de câblage formé à l'étape d) opératoire ;
f) on ménage des trous (SL1) borgnes dans la couche (DE1) de diélectrique au moyen d'un faisceau (LS2) laser, le matériau diélectrique étant enlevé jusqu'aux pistes (LB1) conductrices du premier niveau (VE1) de câblage ;
g) on dépose une deuxième métallisation (M2) à la surface de la couche (DE1) de diélectrique et sur les parois des trous (SL1) borgnes ;
h) on dépose une deuxième couche (AR2) résistante à l'attaque chimique sur la deuxième métallisation (M2);
i) on enlève la deuxième couche (AR2) résistante à l'attaque chimique au moyen d'un faisceau (LS1) laser au moins dans les zones directement adjacentes au dessin futur du chemin des conducteurs du deuxième niveau (VE2) de câblage;
j) on enlève par attaque chimique jusqu'à la surface de la couche (DE 1) de diélectrique les zones de la deuxième métallisation (M2) dégagées à l'étape i);
un contour du dessin du chemin des conducteurs du premier niveau (VE1) de câblage étant prescrit à l'étape c) opératoire, dans lequel les pistes (LB1) conductrices ont une largeur (B1) constante aussi dans la région des trous (SL1) borgnes à produire ultérieurement à l'étape f) opératoire.

7. Procédé suivant la revendication 6, caractérisé par les étapes opératoires supplémentaires suivantes :
k) on dépose une deuxième couche (DE2) de diélectrique sur le deuxième niveau (VE2) de câblage formé à l'étape j) opératoire ;
l) on ménage des trous (SL2) borgnes dans la deuxième couche (DE2) de diélectrique au moyen d'un faisceau (LS2) laser, le matériau diélectrique étant enlevé jusqu'aux pistes (LB2) conductrices du deuxième niveau (VE2) de câblage ;
m) on dépose une troisième métallisation (M3) à la surface de la deuxième couche (DE2) de diélectrique et sur les parois des trous (SL2) borgnes ;
n) on dépose une troisième couche (AR3) résistante à l'attaque chimique sur la troisième métallisation (M3);
o) on enlève la troisième couche (AR3) résistante à l'attaque chimique au moyen d'un faisceau (LS1) laser au mains dans les zones directement adjacentes au dessin futur du chemin des conducteurs du troisième niveau (VE3) de câblage;
p) on enlève par attaque chimique jusqu'à la surface de la deuxième couche (DE2) diélectrique les zones de la troisième métallisation (M3) dégagées à l'étape o);
un contour du dessin du chemin des conducteurs du premier niveau (VE2) de câblage étant prescrit à l'étape i) opératoire, dans lequel les pistes (LB2) conductrices ont une largeur (B2) constante aussi dans la région des trous (SL2) borgnes à produire ultérieurement à l'étape I) opératoire.

8. Procédé suivant l'une des revendications précédentes, caractérisé en ce que l'on dépose la métallisation (M1 ; M2 ; M3) par dépôt sans courant et galvanique de cuivre.

9. Procédé suivant l'une des revendications 6 à 8, caractérisé en ce que l'on dépose la couche (AR1 ; AR2 ; AR3) résistante à l'attaque chimique par dépôt d'étain.

10. Procédé suivant l'une des revendications 6 à 9, caractérisé en ce que ron effectue l'enlèvement partiel de la couche (AR1 ; AR2 ; AR3) résistante à l'attaque chimique au moyen d'un rayonnement (LS1) laser ayant un faisceau qui peut être défléchi.

11. Procédé suivant l'une des revendications précédentes, caractérisé par la production sans masque des trous (SL1 ; SL2) borgnes à l'aide d'un faisceau laser concentré.

12. Procédé suivant l'une des revendications précédentes, caractérisé en ce que le dessin du chemin des conducteurs des niveaux (VE1; VE2 ; VE3) de câblage est limité à une surface d'au maximum 50 mm x 50 mm.

13. Procédé suivant la revendication 12, caractérisé en ce que l'on produit dans les niveaux (VE1 ; VE2 ; VE3) de câblage des pistes (LB1 ; LB2 ; LB3) conductrices ayant une largeur (B1 ; B2 ; B3) d'au maximum 75 µm.

14. Procédé suivant la revendication 12 ou 13, caractérisé en ce que l'on produit des trous (SL1 ; SL2) borgnes ayant un diamètre (D1 ; D2) d'au maximum 55 µm.

15. Procédé suivant l'une des revendications 12 à 14, caractérisé en ce que l'on produit dans les niveaux (VE1 ; VE2 ; VE3) de câblage des dessins du chemin des conducteurs ayant une distance (A1 ; A2 ; A3) entre les pistes (LB1 ; LB2 ; LB3) conductrices d'au maximum 40 µm.

16. Procédé suivant l'une des revendications 12 à 15, caractérisé en ce que l'on dépose des métallisations (M1 ; M2 ; M3) ayant une épaisseur d'au maximum 10 µm.

17. Procédé suivant l'une des revendications 12 à 16, caractérisé en ce que l'on dépose des couches (DE1; DE2) de diélectrique ayant une épaisseur (s) d'au maximum 40 µm.

18. Procédé suivant l'une des revendications 1 à 6, caractérisé en ce que le dessin du chemin des conducteurs des niveaux (VE1 ; VE2 ; VE3) de câblage est limité à une surface d'au maximum 25 mm x 25 mm.

19. Procédé suivant la revendication 18, caractérisé en ce que l'on produit dans les niveaux (VE1 ; VE2 ; VE3) de câblage des pistes (LB1 ; LB2 ; LB3) conductrices ayant une largeur (B1 ; B2 ; B3) d'au maximum 50 µm.

20. Procédé suivant la revendication 18 ou 19, caractérisé en ce que l'on produit des trous (SL1 ; SL2) borgnes ayant un diamètre (D1; D2) d'au maximum 35 µm.

21. Procédé suivant l'une des revendications 18 à 20, caractérisé en ce que l'on produit dans les niveaux (VE1 ; VE2 ; VE3) de câblage des dessins du chemin des conducteurs ayant une distance (A1 ; A2 ; A3) entre les pistes (LB1 ; LB2 ; LB3) conductrices d'au maximum 35 µm.

22. Procédé suivant l'une des revendications 18 à 21, caractérisé en ce que l'on dépose des métallisations (M1 ; M2 ; M3) ayant une épaisseur d'au maximum 5 µm.

23. Procédé suivant l'une des revendications 18 à 22, caractérisé en ce que l'on dépose des couches (DE1; DE2) de diélectrique ayant une épaisseur (s) d'au maximum 25 µm.
